# EUROPEAN PATENT APPLICATION

(11) **EP 1 124 376 A1**
(43) Date of publication of application: **16.08.2001**
(21) Application number: 00250040.3
(22) Date of filing: 09.02.2000
(51) Int. Cl.: H04N 7/167, H04N 7/30, H03M 7/42

(54) **Method and apparatus for generating a data stream protected by encryption**

(71) Applicant: DEUTSCHE THOMSON-BRANDT GMBH, 78048 Villingen-Schwenningen (DE)
(72) Inventor: Gaedke, Klaus, 30659 Hannover (DE); Peters, Hartmut, 30890 Barsinghausen (DE); Schütze, Herbert, 29227 Celle (DE)
(74) Representative: Hartnack, Wolfgang, Dipl.-Ing.

(57) **Abstract**

Proposed systems for encryption and copy protection of digital video or audio data use known data stream encryption algorithms and require a significant amount of additional hardware for the encryption and decryption of the video and audio data. MPEG-2 video uses VLC code tables to generate the encoded data. The receiver has to know about the code tables that have been applied at the encoder in order to be able to decode the VLC-encoded data stream. As long as the encoder VLC code tables are not known the transmitted data cannot be decoded. Therefore the use of any non-standardised non-public VLC code tables when encoding the VLC words is a powerful protection for such MPEG-2 video data. According to the invention several different VLC code tables or several different sets of VLC code tables are used in the encoder and decoder. At regular or irregular time instants a different VLC code table or set of VLC code tables is selected synchronously in the encoder and decoder. The information about the selected VLC code table or set of VLC code tables is transmitted using encryption. A corresponding set of VLC code tables can be stored in the decoder. As an alternative or in addition, an updated and possibly encrypted VLC code table or set of VLC code tables can be transmitted from the encoder to the decoder, whereby the information about the selected VLC code table or set of VLC code tables can be transmitted in a non-encrypted format. No real-time encryption/decryption processing of the VLC code words and therefore no high-speed complex hardware is required.

## Description

The invention relates to a method, to an encoding apparatus and to a decoding apparatus for protecting a data stream with code tables using encryption in a data encoder or for decoding a protected data stream with code tables using a corresponding decryption in a data decoder.

### Background

Encryption and copy protection of digital video or audio data are widely discussed topics. Several proposals like DTCP (digital transmission content protection) or XCA (extended conditional access) exist. These proposals use known data stream encryption algorithms and require a significant amount of additional hardware for the encryption and decryption of the video and audio data.
EP-A-0 582 122 discloses a specific kind of encryption wherein VLC (variable length code) code words required for decoding encoded digital video or audio data are encrypted using permanent scrambling of the VLC code words to be transmitted. The scrambled code words are unusable in a standard decoder because either the transmitted scrambled code words are mis-interpreted or the transmitted scrambled code words cannot be found in the VLC code book tables stored in the receiver.

### Invention

For example the MPEG-2 video standard includes the use of VLC code in order to generate the encoded data. The receiver has to know about the code tables that have been applied at the encoder in order to be able to decode the variable-length encoded data stream. As long as the encoder VLC code tables are not known the transmitted data cannot be decoded. Therefore, the use of any non-standardised non-public VLC code tables when encoding the VLC words is a powerful data content protection for such MPEG-2 video data. The required VLC code tables can be regarded as being a key for access to the data content.
A disadvantage of the system described in EP-A-0 582 122 is that real-time encryption/decryption processing of the VLC code words is required. However, real-time encryption and scrambling of video or audio data code words and the corresponding decryption and descrambling needs high-speed complex hardware.
According to the invention several different VLC code tables or several different sets of VLC code tables are used in the encoder and decoder. At regular or irregular time instants a different VLC code table or set of VLC code tables is selected synchronously in the encoder and decoder. The information about the selected VLC code table or set of VLC code tables is transmitted using encryption. A corresponding set of VLC code tables can be stored in the decoder.
As an alternative or in addition, an updated VLC code table or set of VLC code tables can be transmitted from the encoder to the decoder. This improves the security of the system.
Preferably the transmitted VLC code table or set of VLC code tables is encrypted, too. In that case the abbove information about the selected VLC code table or set of VLC code tables can be transmitted in a non-encrypted format.

The encoder in the transmitter and the decoder in the receiver need to be modified slightly only, to enable the above described VLC encoding and VLC decoding with user-definable VLC code tables. Nearly no additional hardware is required for implementing the invention.
Advantageously the encryption and decryption can be carried out without real-time demand.

It is one object of the invention to disclose a method for protection of VLC-encoded data content without real-time encryption or decryption requirements. This object is achieved by the method disclosed in claim 1.

It is a further object of the invention to disclose an encoding apparatus and a decoding apparatus, which utilise the inventive method. This object is achieved by the apparatuses disclosed in claims 6 and 8.

In principle, the inventive method is suited for protecting a data stream using encryption in a data encoder or corresponding decryption in a data decoder, wherein code tables required for the encoding and for the decoding of said data stream are changed at regular or non-regular time instants.

Advantageous additional embodiments of the inventive method are disclosed in the respective dependent claims.

In principle the inventive encoding apparatus is suited for protecting a data stream to be encoded using encryption, and includes:
- means for encoding an input signal;
- subsequent means for further encoding using code tables, wherein said means for further encoding use a code table or code tables required for the encoding of said data stream and wherein the code table or code tables is/are changed at regular or non-regular time instants.

In principle the inventive decoding apparatus is suited for decoding a protected data stream using decryption, and includes:
- means for initial decoding using code tables;
- subsequent means for further decoding and for providing reconstructed data,
- means for identifying received code table information from said data stream which means are arranged upstream said means for initial decoding;
- means for decrypting and evaluating said received **code table information** and for controlling said means for initial decoding such that the code table or code tables required for correct initial decoding are used,
wherein said means for initial decoding use a code table or code tables that is/are changed at regular or non-regular time instants.

Advantageous additional embodiments of the inventive apparatuses are disclosed in the respective dependent claims.

### Drawings

Exemplary embodiments of the invention are described with reference to the accompanying drawings, which show in:

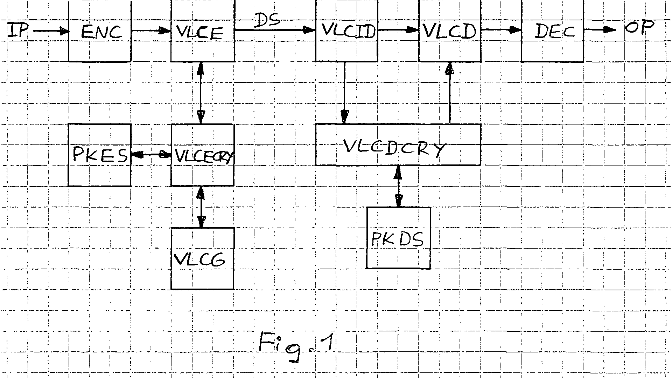

- Fig. 1: block diagram of an inventive encoder and decoder.

### Exemplary embodiments

In Fig. 1 an input signal IP passes through an encoder ENC to a VLC encoder VLCE.
If ENC is a video encoder it may include in a well-known loop a subtracting combiner, a DCT transformer, a quantiser, an inverse quantiser, an inverse DCT transformer and a picture block values predictor. The predicted and correspondingly motion compensated pixel block values are fed to the subtracting input of said combiner. In case of intraframe or intrafield encoding the combiner outputs the original input signal pixel block values to said DCT transformer. In case of interframe or interfield, i.e. predictive encoding the combiner outputs to said DCT transformer the pixel block difference values between original input signal pixel block values and corresponding reconstructed predicted and motion compensated pixel block values. The output signal of the quantiser is then fed to VLCE which usually includes a buffer the filling level of which controls the characteristic of the quantiser and of the inverse quantiser. VLCE output a data stream DS which usually may or may not have a constant data rate.
If ENC is an audio encoder it may include a window function, a spectral transformer, a subsampler, a quantiser and a scale factor or exponent calculator. For example the scale factors or exponents and/or the quantised coefficients or mantissas and/or their word length can be encoded in VLCE using either VLC code tables or non-VLC code tables.
VLCE may generally use one VLC code table or different VLC code tables for different types of data of the data stream to be encoded.
The VLC code tables used in VLCE can either be selected from stored ones, or can be updated. They are taken from a VLC generator VLCG. VLCG may store a selection of VLC tables or may calculate new VLC tables in case of updating. The encryption mentioned above is generated using a public key encryption system PKES. PKES controls VLCG and VLCE via a VLC encryption controller VLCECRY. The encryption can be carried out in different ways:
a) Within the transmitted data stream an encrypted information is transmitted about the VLC code table or tables used in VLCE, and about that to be used in a corresponding VLC decoder VLCD in the receiver decoder, out of the set of stored ones. The encrypted information describes at which time instant which of the stored VLC code tables is or are to be used in VLCE and in the receiver decoder.
b) The VLC code table or tables used in VLCE and to be used in the receiver VLCD, are encrypted before being transmitted. The time instant at which the new decrypted VLC code table or tables are to be used in VLCE and in the receiver decoder can be linked to a time stamp or reference time transmitted together with the data stream. This time stamp or reference time can be encrypted, too.
c) A first combination of a) and b) wherein beside the currently required VLC code table or tables no other of such VLC code tables for prior or later use are stored in the receiver decoder.
d) A second combination of a) and b) wherein beside the currently required VLC code table or tables other of such VLC code tables for prior or later use are stored in the receiver decoder.
e) A third combination of a) and b) and eventually c) or d) wherein said information about the VLC code table or tables used in VLCE, and about that to be used in a corresponding VLC decoder VLCD in the receiver decoder is transmitted in a non-encrypted format.
f) A further embodiment of b) and eventually c) or d) wherein said information about the VLC code table or tables used in VLCE, and about that to be used in a corresponding VLC decoder VLCD in the receiver decoder is transmitted in a non-encrypted format.

The receiver decoder identifies in a VLC information detector VLCID arranged at its input the encrypted VLC information received with the data stream. This VLC information becomes decrypted in a VLC decryptor VLCDCRY and is thereafter used in VLC decoder VLCD when carrying out the VLC decoding. VLCDCRY is controlled by a public key decryption system PKDS. The VLC-decoded data words are further processed in a decoder DEC which supplies the reconstructed video or audio output data OP. VLCD and DEC carry out the inverse functions corresponding to that in ENC and VLCE in the transmitter encoder.

The decrypted VLC information is used in VLCD according to points a) to f) above:
A) At least one of the VLC code tables stored e.g. in VLCD is used according to the transmitted selection and/or time information.
B) The new decrypted VLC code table or tables which is/are to be used in VLCD and eventually at which time instant.
C) A corresponding first combination of A) and B).
D) A corresponding second combination of A) and B).
E) A corresponding third combination of A) and B) and eventually C) or D) wherein said information about the VLC code table or tables to be used in VLCD is transmitted in a non-encrypted format.
F) A corresponding further embodiment of B) and eventually C) or D) wherein said information about the VLC code table or tables to be used in VLCD is transmitted in a non-encrypted format.

For PKES and PKDS a well-known public key encryption algorithm like e.g. RSA or DES can be used.

The additional steps carried out in the receiver are less hardware demanding when compared to the implementation of actual copy protecting schemes which include the encryption and decryption of the complete MPEG-2 data stream every time it is transmitted from one device to another.

Advantageously, a data stream encoded with non-standardised, non-public VLC code tables can be published and copied without further treatment - i.e. copy protection - because such data stream cannot be decoded and displayed or presented unless the correspondingly required VLC code tables are known to the decoder.
Advantageously, the encryption and copy protection problem is transferred from dynamic operation in real-time to static operation of encryption and decryption without real-time demands. Further, the encryption of the VLC code tables also allows conditional access to the data content because it allows the selection of such decoders which are capable of decoding the VLC code words and the corresponding data stream. The invention is applicable to all VLC-based coding standards like MPEG-1 video and/or audio layer 3, MPEG-2 video and/or audio layer 3 and AAC, H.261, H.263, and MPEG-4 video and/or audio layer 3 and AAC.
The invention is not limited to VLC-based coding standards but can be used in any encoding/decoding system where code word tables are required for the decoding, for instance in the MPEG-1 or MPEG-2 audio layer 1 or layer 2 standards, in the AC-3 and MD audio coding standards, and in the DV video coding standard.

## Claims

1. Method for protecting a data stream (DS) using encryption (PKES) in a data encoder (ENC, VLCE) or corresponding decryption (PKDS) in a data decoder (VLCD, DEC),
**characterised** in that code tables (VLCG) required for the encoding and for the decoding of said data stream are changed at regular or irregular time instants.

2. Method according to claim 1, wherein said data encoder or data decoder is a video or audio encoder or video or audio decoder, respectively.

3. Method according to claim 1 or 2, wherein said code tables are VLC code tables.

4. Method according to any of claims 1 to 3, wherein the code tables between it is changed are stored (VLCG) in said data encoder or data decoder and the required change command is encrypted (PKES, VLCECRY) or decrypted (PKDS, VLCDCRY), respectively.

5. Method according to any of claims 1 to 4, wherein for changing a code table or code tables respective updated code tables (VLCG) are transmitted to said data decoder in an encrypted (PKES, VLCECRY) format and are decrypted (PKDS, VLCDCRY) in said data decoder before use in the decoding (VLCD), whereby the required change command can be transmitted in a non-encrypted format.

6. Encoding apparatus for protecting a data stream (DS) to be encoded using encryption (PKES), including:
- means (ENC) for encoding an input signal (IP);
- subsequent means (VLCE) for further encoding using code tables,
**characterised** in that said means (VLCE) for further encoding use a code table or code tables required for the encoding of said data stream, wherein the code table or code tables is/are changed at regular or irregular time instants.

7. Encoding apparatus according to claim 6, wherein said data stream contains video or audio data and/or wherein said code tables are VLC code tables.

8. Decoding apparatus for decoding a protected data stream (DS) using decryption (PKDS), including:
- means (VLCD) for initial decoding using code tables;
- subsequent means (DEC) for further decoding and for providing (OP) reconstructed data,
**characterised** by:
- means (VLCID) for identifying received code table information from said data stream, which means are, arranged upstream said means for initial decoding;
- means (VLCDCRY, PKDS) for decrypting and evaluating said received code table information and for controlling said means (VLCD) for initial decoding such that the code table or code tables required for correct initial decoding are used,
wherein said means (VLCD) for initial decoding use a code table or code tables that is/are changed at regular or irregular time instants.

9. Decoding apparatus according to claim 8, wherein said data stream contains video or audio data and/or wherein said code tables are VLC code tables.

10. Apparatus according to any of claims 6 to 9, wherein the code tables between it is changed are stored in said apparatus and the required change command is encrypted in said encoding apparatus before transmission or decrypted in said decoding apparatus, respectively, or wherein for changing a code table or code tables, respective updated code tables are used that are transmitted by said encoding apparatus in an encrypted (PKES, VLCECRY) format or are decrypted (PKDS, VLCDCRY) in said decoding apparatus before use, respectively, whereby the required change command can be transmitted in a non-encrypted format.
